# EUROPÄISCHE PATENTSCHRIFT

(11) **EP 2 347 450 B1**
(45) Veröffentlichungstag und Bekanntmachung des Hinweises auf die Patenterteilung: **16.09.2015**
(21) Anmeldenummer: 09740668.0
(22) Anmeldetag: 15.10.2009
(51) Int. Cl.: H01L 31/048, C08K 5/20

(54) **HERSTELLUNG VON SOLARZELLENMODULEN**
PRODUCTION OF SOLAR CELL MODULES
FABRICATION DE MODULES DE CELLULES SOLAIRES

(30) Priorität: 13.11.2008 DE 102008043713
(43) Veröffentlichungstag der Anmeldung: 27.07.2011
(73) Patentinhaber: Evonik Röhm GmbH, 64293 Darmstadt (DE)
(72) Erfinder: BATTENHAUSEN, Peter, 63636 Brachttal-Udenhain (DE); BECKER, Ernst, 64625 Bensheim (DE); SCHULTES, Klaus, 65193 Wiesbaden (DE); STROHKARK, Sven, 64283 Darmstadt (DE)
(74) Vertreter: Wolf, Oliver
(86) Internationale Anmeldenummer: PCT/EP2009/063438
(87) Internationale Veröffentlichungsnummer: WO 2010/054905

(56) Entgegenhaltungen:
- EP-A1- 0 714 931
- EP-A2- 1 065 731
- US-A1- 2002 161 164
- CIBA-GEIGY AG ET AL: "UV-light stable polymethylmethacrylate with excellent color stability (Ciba-Geigy AG, Basle)" RESEARCH DISCLOSURE, MASON PUBLICATIONS, HAMPSHIRE, GB, Bd. 309, Nr. 105, 1. Januar 1990 (1990-01-01), XP007114682 ISSN: 0374-4353
- ANONYMOUS: "UV Light Absorber" 11. Oktober 2007 (2007-10-11), XP002567621 Gefunden im Internet: URL:http://www.npadditives.com/data/produc ts/TDS/TDS%20ELC-312.pdf> [gefunden am 2010-02-09]

## Beschreibung

Die vorliegende Erfindung betrifft die Herstellung von Solarzellenmodulen sowie die entsprechenden Solarzellenmodule.

### STAND DER TECHNIK

Eine Solarzelle oder photovoltaische Zelle ist ein elektrisches Bauelement, das die im Licht, insbesondere die im Sonnenlicht, enthaltene Strahlungsenergie direkt in elektrische Energie umwandelt. Die physikalische Grundlage der Umwandlung ist der photovoltaische Effekt, der ein Sonderfall des inneren photoelektrischen Effekts ist.

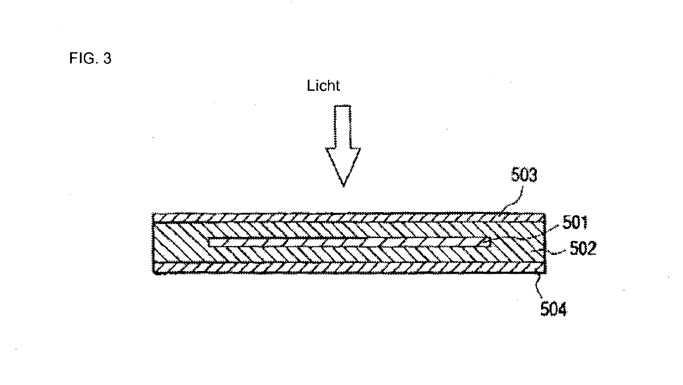

Fig. 3 ist ein schematischer Querschnitt, der die Grundstruktur eines Solarzellenmoduls zeigt. In Fig. 3 bezeichnet 501 ein photovoltaisches Element, 502 ein Verfestigungsmittel, 503 eine Scheibe und 504 eine Rückwand. Sonnenlicht strahlt auf die lichtempfindliche Oberfläche des photovoltaischen Elements 501 ein, indem es die Scheibe 503 und das Verfestigungsmittel 502 durchdringt, und wird in elektrische Energie umgewandelt. Der gebildete Strom wird von Ausgangsklemmen (nicht gezeigt) abgegeben.

Das photovoltaische Element kann keine extremen Außenbedingungen aushalten, weil es leicht korrodiert und sehr zerbrechlich ist. Es muss daher durch ein geeignetes Material bedeckt und geschützt werden. In den meisten Fällen wird dies erreicht, indem man das photovoltaische Element unter Verwendung eines geeigneten Verfestigungsmittels zwischen einer transparenten Scheibe mit Witterungsbeständigkeit, wie z.B. einer Glasscheibe, und einer Rückwand mit exzellenter Feuchtigkeitsbeständigkeit und einem hohen elektrischen Widerstand einlegt und laminiert.

Als Verfestigungsmittel für Solarzellen werden häufig Polyvinylbutyral und Ethylen-Vinylacetatcopolymere (EVA) verwendet. Dabei zeigen insbesondere vernetzbare EVA-Zusammensetzungen exzellente Eigenschaften, wie eine gute Wärmebeständigkeit, eine hohe Witterungsbeständigkeit, eine große Transparenz und eine gute Kosteneffizienz.

Das Solarzellenmodul soll eine hohe Beständigkeit aufweisen, weil es draußen für eine lange Zeit verwendet werden soll. Demzufolge muss das Verfestigungsmittel u. a. eine exzellente Witterungsbeständigkeit und eine hohe Wärmeformbeständigkeit aufweisen. Jedoch werden häufig ein Licht-induzierter und/oder thermisch-induzierter Abbau des Verfestigungsmittels und infolge dessen eine Gelbverfärbung des Verfestigungsmittels und/oder ein Abschälen vom photovoltaischen Element beobachtet, wenn das Modul für eine lange Zeit, wie z.B. zehn Jahre, draußen verwendet wird. Die Gelbverfärbung des Verfestigungsmittels führt zu einer Abnahme des nutzbaren Anteils des einfallenden Lichts und demzufolge zu einer geringeren elektrischen Leistung. Andererseits ermöglicht ein Abschälen vom photovoltaischen Element das Eindringen von Feuchtigkeit, welches zu Korrosion des photovoltaischen Elements selber oder von metallischen Teilen im Solarzellenmodul führen kann und ebenfalls eine Verschlechterung der Solarzellenmodulleistung zur Folge hat.

Obwohl die gewöhnlich verwendeten EVAs an sich gute Verfestigungsmittel sind, werden sie durch Hydrolyse und/oder Pyrolyse graduell abgebaut. Mit der Zeit wird durch Wärme oder Feuchtigkeit Essigsäure freigesetzt. Dies führt zu einer Gelbverfärbung des Verfestigungsmittels, zu einer Abnahme der mechanischen Festigkeit und zu einer Abnahme der Adhäsionsstärke des Verfestigungsmittels. Weiterhin wirkt die freigesetzte Essigsäure als Katalysator und beschleunigt den Abbau zusätzlich. Darüber hinaus tritt das Problem auf, dass das photovoltaische Element und/oder andere Metallteile im Solarzellenmodul durch die Essigsäure korrodiert werden.

Zur Lösung dieser Probleme schlägt die europäische Patentanmeldung EP 1 065 731 A2 die Verwendung eines Solarzellenmoduls vor, das ein photovoltaisches Element und ein polymeres Verfestigungsmittel umfasst, wobei das polymere Verfestigungsmittel ein Ethylen-Acrylester-Acrylsäure-Terpolymer, ein Ethylen- Acrylester-Maleinsäureanhydrid-Terpolymer, ein Ethylen-Methacrylsäureester-Acrylsäureester-Terpolymer, ein Ethylen-Acrylsäureester-Methacrylsäure-Terpolymer, ein Ethylen-Methacrylsäureester-Methacrylsäure-Terpo!ymer und/oder ein Ethylen-Methacrylsäureester-Maleinsäureanhydrid-Terpolymer enthalten soll. Jedoch ist sowohl die Witterungsbeständigkeit als auch die Effektivität derartiger Solarzellenmodule beschränkt.

Aus dem Stand der Technik ist auch die Verbesserung der Witterungsbeständigkeit von Acrylformmassen durch die Verwendung geeigneter UV-Absorber bekannt.

So beschreibt die DE 103 11 641 A1 Bräunungshilfen, die einen Polymethylmethacrylat-Formkörper umfassen, der 0,005 Gew.-% bis 0,1 Gew.-% eines UV-Stabilisators gemäß Formel (I) enthält 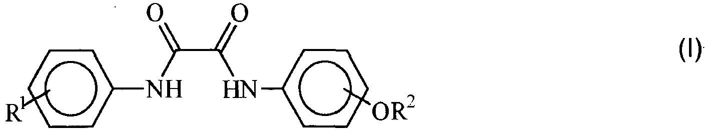 worin die Reste R¹ und R² unabhängig einen Alkyl- oder Cycloalkylrest mit 1 bis 20 Kohlenstoffatomen darstellen.

Hinweise auf die Verwendung der Formkörper für die Herstellung von Solarzellenmodulen sind der Druckschrift jedoch nicht zu entnehmen.

DE 38 38 480 A1 offenbart Methylmethacrylat-Polymere und -Copolymere, die
a) eine Oxalsäureanilid- oder 2,2,6,6-Tetramethylpiperidinverbindung als Stabilisator gegen die Lichtschädigung und
b) eine flammhemmende organische Phosphor-Verbindung
enthalten.

Hinweise auf die Verwendung der Zusammensetzung für die Herstellung von Solarzellenmodulen sind der Druckschrift jedoch nicht zu entnehmen.

JP 2005-298748 A stellt Formteile aus einem Methacrylharz zur Verfügung, die bevorzugt 100 Gew.-Teile Methacrylharz, umfassend 60-100 Gew.-% Methylmethacrylateinheiten und 0-40 Gew.-% anderer copolymerisierbarer Vinylmonomereinheiten, und 0,005-0,15 Gew.-% 2-(2-Hydroxy-4-n-octyloxyphenyl)-4,6- bis(2,4-dimethylphenyl)-1,3,5-triazin und/oder 2-Hydroxy-4-octyloxybenzophenon enthalten. Die Formteile sollen eine deutliche Barriere für UV-Strahlen aufweisen und eine Transparenz von höchstens 20% bei 340 nm und eine Transparenz von mindestens 70% bei 380 nm zeigen, gemessen an Formteilen mit einer Dicke im Bereich von 0,5 bis 5 mm.

Die Formteile sollen insbesondere als Beleuchtungsabdeckungen eingesetzt werden. Hinweise auf einen Einsatz der Formteile für die Herstellung von Solarzellenmodulen sind der Druckschrift jedoch nicht zu entnehmen.

### ZUSAMENFASSUNG DER ERFINDUNG

Es ist daher eine Aufgabe der vorliegenden Erfindung, Möglichkeiten zur Verringerung des Leistungsabfalls einer Solarzelle bei Langzeitnutzung im Freien, insbesondere bei hoher Temperatur und/oder hoher Luftfeuchtigkeit, aufzuzeigen. Zu diesem Zweck wurden insbesondere nach Wegen gesucht, eine exzellente Witterungsbeständigkeit, eine möglichst hohe Wärmeformbeständigkeit und eine möglichst große Lichtdurchlässigkeit sowie eine möglichst geringe Wasserabsorption zu erreichen. Weiterhin wurde eine möglichst geringe Freisetzung von korrosionsfördernden Substanzen, insbesondere von Säuren, und eine möglichst starke Adhäsion an den verschiedenen Grundelementen eines Solarzellenmoduls gewünscht.

Diese sowie weitere nicht konkret genannte Aufgaben, die sich aus den einleitend diskutierten Zusammenhängen jedoch in nahe liegender Weise ergeben, werden durch die Verwendung einer Formmasse mit allen Merkmalen des vorliegenden Patentanspruchs 1 gelöst. Die auf Anspruch 1 rückbezogenen Unteransprüche beschreiben besonders zweckmäßige Varianten der Erfindung. Weiterhin werden auch die entsprechenden Solarzellenmodule unter Schutz gestellt.

Dadurch, dass man
a) mindestens ein Polyalkyl(meth)acrylat und
b) mindestens eine Verbindung gemäß Formel (I) 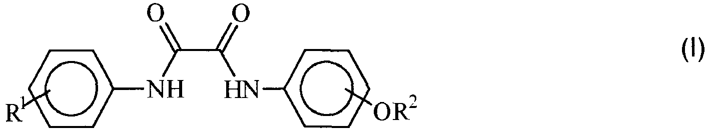 worin die Reste R¹ und R² unabhängig einen Alkyl- oder Cycloalkylrest mit 1 bis 20 Kohlenstoffatomen darstellen,
zur Herstellung von Solarzellenmodulen, insbesondere zur Herstellung von Lichtkonzentratoren für Solarzellenmodule, einsetzt,

gelingt es auf nicht ohne weiteres vorhersehbare Weise, einen Leistungsabfall einer Solarzelle bei Langzeitnutzung im Freien, insbesondere bei hoher Temperatur und/oder hoher Luftfeuchtigkeit, bestmöglich zu verhindern. Insbesondere wird eine exzellente Witterungsbeständigkeit, eine sehr hohe Wärmebeständigkeit und eine sehr große Lichtdurchlässigkeit sowie eine überaus geringe Wasserabsorption erreicht. Weiterhin werden auch bei Langzeitnutzung im Freien keine korrosionsfördernden Substanzen freigesetzt und es wird eine sehr starke Adhäsion an den verschiedenen Grundelementen eines Solarzellenmoduls erreicht.

Die hier vorgestellte Lösung erlaubt die effiziente Nutzung von "brauchbarem" Licht im sichtbaren Wellenlängenbereich. Gleichzeitig werden andere Wellenlängenbereiche, insbesondere im UV-Bereich, welche nicht zur Erzeugung von Strom genutzt werden können, effektiv absorbiert. Durch diese Absorption wird die Witterungsbeständigkeit der Solarzellenmodule erhöht. Weiterhin wird durch die Absorption ein sich nachteilig auswirkendes Aufheizen der Lichtkollektoren verhindert, ohne dass Kühlelemente für diese Zwecke eingesetzt werden müssen, die Lebensdauer der Solarzellenmodule wird verlängert und ihre Gesamtleistung und Effektivität wird gesteigert.

Durch die erfindungsgemäße Vorgehensweise ergeben sich insbesondere die folgenden Vorteile:

Es wird ein Solarzellenmodul mit exzellenter Witterungsbeständigkeit, Wärmebeständigkeit und Feuchtigkeitsbeständigkeit zugänglich gemacht. Es tritt kein Abschälen auf, selbst wenn das Modul Außenbedingungen für eine lange Zeit ausgesetzt wird. Weiterhin wird die Witterungsbeständigkeit verbessert, da auch bei hohen Temperaturen und hoher Feuchtigkeit keine Säure freigesetzt wird. Da keine Korrosion des photovoltaischen Elements durch Säure auftritt, wird eine stabile dauerhafte Leistung der Solarzelle über eine lange Zeit aufrecht erhalten.

Weiterhin werden Materialien verwendet, deren Witterungsbeständigkeit, Wärmeformbeständigkeit und Feuchtigkeitsbeständigkeit überragend sind und die eine exzellente Lichtdurchlässigkeit aufweisen, welches die Herstellung von sehr guten Solarzellenmodulen ermöglicht.

### BESCHREIBUNG DER ZEICHNUNGEN

Fig. 1 ist ein schematischer Querschnitt eines bevorzugten Solarzellenmoduls gemäß der vorliegenden Erfindung.
Figs. 2a und 2b sind schematische Querschnitte, die die Grundstruktur eines photovoltaischen Elements, das im Solarzellenmodul nach Fig. 1 bevorzugt verwendet wird, bzw. eine Aufsicht auf die lichtempfindliche Fläche des photovoltaischen Elements zeigen.
Fig. 3 ist ein schematischer Querschnitt einer konventionellen Solarzelle.

### Bezugszeichen

Figur 1
   - 101: photovoltaisches Element
   - 102: Verfestigungsmittel
   - 103: Scheibe
   - 104: Verfestigungsmittel
   - 105: Rückwand
Figur 2a
   - 201: leitendes Substrat
   - 202: reflektierende Schicht
   - 203: photoaktive Halbleiterschicht
   - 204: transparente leitfähige Schicht
   - 205: Sammelelektrode
   - 206a: Abgreifklemme
   - 206b: Abgreifklemme
   - 207: leitende, adhäsive Pasten
   - 208: leitende Paste oder Lötzinn
Figur 2b
   - 201: leitendes Substrat
   - 202: reflektierende Schicht
   - 203: photoaktive Halbleiterschicht
   - 204: transparente leitfähige Schicht
   - 205: Sammelelektrode
   - 206a: Abgreifklemme
   - 206b: Abgreifklemme
   - 207: leitende, adhäsive Pasten
Figur 3
   - 501: photovoltaisches Element
   - 502: Verfestigungsmittel
   - 503: Scheibe
   - 504: Rückwand

### DETAILLIERTE BESCHREIBUNG DER ERFINDUNG

Im Rahmen der vorliegenden Erfindung werden
a) mindestens ein Polyalkyl(meth)acrylat und
b) mindestens eine Verbindung gemäß Formel (I) 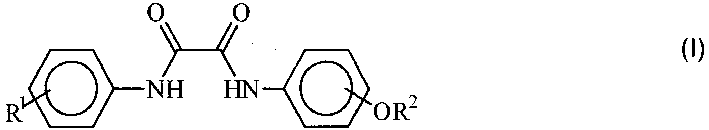
worin die Reste R¹ und R² unabhängig einen Alkyl- oder Cycloalkylrest mit 1 bis 20 Kohlenstoffatomen darstellen,
zur Herstellung von Solarzellenmodulen eingesetzt. Dabei können diese Komponenten gemeinsam in einer Zusammensetzung, z. B. in Mischung in einer Formmasse, zur Herstellung eines gemeinsamen Elements, wie z. B. eines Formteils, des Solarzellenmoduls verwendet werden. Es ist aber auch möglich, dass sie jeweils separat für die Herstellung von verschiedenen Einzelelementen eines Solarzellenmoduls eingesetzt werden.

Das Polyalkyl(meth)acrylat kann einzeln oder auch in Mischung von mehreren verschiedenen Polyalkyl(meth)acrylaten eingesetzt werden. Des Weiteren kann das Polyalkyl(meth)acrylat auch in Form eines Copolymers vorliegen.

Im Rahmen der vorliegenden Erfindung werden Homo- und Copolymere von C₁-C₁₈-Alkyl(meth)acrylaten, zweckmäßigerweise von C₁-C₁₀-Alkyl(meth)acrylaten, insbesondere von C₁-C₄-Alkyl(meth)acrylatpolymeren, die ggf. noch davon verschiedene Monomereinheiten enthalten können, besonders bevorzugt.

Die Schreibweise (Meth)acrylat bedeutet hier sowohl Methacrylat, wie z. B. Methylmethacrylat, Ethylmethacrylat usw., als auch Acrylat, wie z. B. Methylacrylat, Ethylacrylat usw., sowie Mischungen aus beiden Monomeren.

Die Verwendung von Copolymeren, die 70 Gew.-% bis 99 Gew.-%, insbesondere 70 Gew.-% bis 90 Gew.-%, C₁-C₁₀-Alkyl(meth)acrylate enthalten, hat sich ganz besonders bewährt. Bevorzugte C₁-C₁₀-Alkylmethacrylate umfassen Methylmethacrylat, Ethylmethacrylat, Propylmethacrylat, Isopropylmethacrylat, n-Butylmethacrylat, Isobutylmethacrylat, tert.-Butylmethacrylat, Pentylmethacrylat, Hexylmethacrylat, Heptylmethacrylat, Oktylmethacrylat, Isooctylmethacrylat und Ethylhexylmethacrylat, Nonylmethacrylat, Decylmethcrylat sowie Cycloalkylmethacrylate, wie beispielsweise Cyclohexylmethacrylat, Isobornylmethacrylat oder Ethylcyclohexlmethacrylat. Bevorzugte C₁-C₁₀-Alkylacrylate umfassen Methylacrylat, Ethylacrylat, Propylacrylat, Isopropylacrylat, n-Butylacrylat, Isobutylacrylat, tert.-Butylacrylat, Pentylacrylat, Hexylacrylat, Heptylacrylat, Octylacrylat, Isooctylacrylat, Nonylacrylat, Decylacrylat und Ethylhexylacrylat sowie Cycloalkylacrylate, wie beispielsweise Cyclohexylacrylat, Isobornylacrylat oder Ethycyclohexlacrylat.

Ganz besonders bevorzugte Copolymere umfassen 80 Gew.-% bis 99 Gew.-% Methylmethacrylat (MMA)-Einheiten und 1 Gew.-% bis 20 Gew.-%, vorzugsweise 1 Gew.-% bis 5 Gew.-%, C₁-C₁₀-Alkylacrylat-Einheiten, insbesondere Methylacrylat-, Ethylacrylat- und/oder Butylacrylat-Einheiten. Die Verwendung des bei der Firma Röhm GmbH erhältlichen Polymethylmethacrylats PLEXIGLAS^{®} 7N hat sich in diesem Zusammenhang ganz besonders bewährt.

Das Polyalkyl(meth)acrylat kann durch an sich bekannte Polymerisationsverfahren hergestellt werden, wobei radikalische Polymerisationsverfahren, insbesondere Substanz-, Lösungs-, Suspensions- und Emulsionspolymerisationsverfahren besonders bevorzugt werden. Für diese Zwecke besonders geeignete Initiatoren umfassen insbesondere Azoverbindungen, wie 2,2'-Azobis-(isobutyronitril) oder 2,2'-Azobis(2,4-dimethylvaleronitril), Redox-Systeme, wie beispielsweise die Kombination von tertiären Aminen mit Peroxiden oder Natriumdisulfit und Persulfate von Kalium, Natrium oder Ammonium oder bevorzugt Peroxide (vgl. hierzu beispielsweise H. Rauch-Puntigam, Th. Völker, "Acryl- und Methacrylverbindungen", Springer, Heidelberg, 1967 oder Kirk-Othmer, Encyclopedia of Chemical Technology, Vol. 1, Seiten 386ff, J. Wiley, New York, 1978). Beispiele besonders geeigneter Peroxid-Polymerisationsinitiatoren sind Dilauroylperoxid, tert.-Butylperoctoat, tert.-Butylperisononanoat, Dicyclohexylperoxidicarbonat, Dibenzoylperoxid und 2,2-Bis-(tert.-butylperoxy)-butan. Man kann auch bevorzugt die Polymerisation mit einem Gemisch verschiedener Polymerisationsinitiatoren unterschiedlicher Halbwertzeit durchführen, beispielsweise Dilauroylperoxid und 2,2-Bis-(tert.-butylperoxy)-butan, um den Radikalstrom im Verlauf der Polymerisation sowie bei verschiedenen Polymerisationstemperaturen konstant zu halten. Die eingesetzten Mengen an Polymerisationsinitiator liegen im Allgemeinen bei 0,01 Gew.-% bis 2 Gew.-% bezogen auf das Monomerengemisch.

Die Polymerisation kann sowohl kontinuierlich als auch chargenweise durchgeführt werden. Nach der Polymerisation wird das Polymer über herkömmliche Isolier- und Trennschritte, wie z. B. Filtration, Koagulation und Sprühtrocknung, gewonnen.

Die Einstellung der Kettenlängen der Polymerisate oder Copolymerisate kann durch Polymerisation des Monomers oder Monomerengemisches in Gegenwart von Molekulargewichtsreglern erfolgen, wie insbesondere von den dafür bekannten Mercaptanen, wie beispielsweise n-Butylmercaptan, n-Dodecylmercaptan, 2-Mercaptoethanol oder 2-Ethylhexylthioglycolat, Pentaerythrittetrathioglycolat; wobei die Molekulargewichtsregler im Allgemeinen in Mengen von 0,05 Gew.-% bis 5 Gew.-% bezogen auf das Monomer oder Monomerengemisch, bevorzugt in Mengen von 0,1 Gew.-% bis 2 Gew.-% und besonders bevorzugt in Mengen von 0,2 Gew.-% bis 1 Gew.-%, bezogen auf das Monomer oder Monomerengemisch, eingesetzt werden (vgl. beispielsweise H. Rauch-Puntigam, Th. Völker, "Acryl- und Methacrylverbindungen", Springer, Heidelberg, 1967; Houben-Weyl, Methoden der organischen Chemie, Bd. XIV/1, Seite 66, Georg Thieme, Heidelberg, 1961 oder Kirk-Othmer, Encyclopedia of Chemical Technology, Vol. 1, Seiten 296ff, J. Wiley, New York, 1978). Besonders bevorzugt wird als Molekulargewichtsregler n-Dodecylmercaptan eingesetzt.

Im Rahmen der vorliegenden Erfindung wird weiterhin mindestens eine Verbindung gemäß Formel (I) 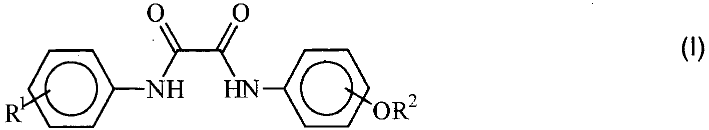 worin die Reste R¹ und R² unabhängig einen Alkyl- oder Cycloalkylrest mit 1 bis 20 Kohlenstoffatomen, besonders bevorzugt mit 1 bis 8 Kohlenstoffatomen, darstellen, zur Herstellung der Solarzellenmodule eingesetzt. Die aliphatischen Reste sind vorzugsweise linear oder verzweigt und können Substituenten, wie beispielsweise Halogenatome aufweisen.

Zu den bevorzugten Alkylgruppen gehören die Methyl-, Ethyl-, Propyl-, Isopropyl-, 1-Butyl-, 2-Butyl-, 2-Methylpropyl-, tert.-Butyl-, Pentyl-, 2-Methylbutyl-, 1,1-Dimethylpropyl-, Hexyl-, Heptyl-, Octyl-, 1,1,3,3-Tetramethylbutyl, Nonyl-, 1-Decyl-, 2-Decyl-, Undecyl-, Dodecyl-, Pentadecyl- und die Eicosyl-Gruppe.

Zu den bevorzugten Cycloalkylgruppen gehören die Cyclopropyl-, Cyclobutyl-, Cyclopentyl-, Cyclohexyl-, Cycloheptyl- und die Cyclooctyl-Gruppe, die gegebenenfalls mit verzweigten oder nicht verzweigten Alkylgruppen substituiert sind.

Besonders bevorzugt wird die Verbindung der Formel (II) 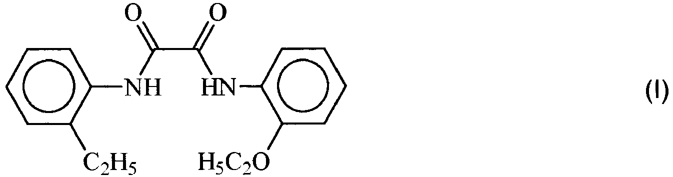 eingesetzt.

Diese Verbindung ist kommerziell von Clariant unter dem Handelsnamen ^{®}Sanduvor VSU sowie von Ciba Geigy unter dem Handelsnamen ^{®}Tinuvin 312 erhältlich.

Im Rahmen der vorliegenden Erfindung kann es ggf. hilfreich sein, dem Fachmann wohlbekannte Hilfsmittel zusätzlich einzusetzen. Bevorzugt werden externe Sctimiermittel, Antioxidantien, Flammschutzmittel, weitere UV-Stabilisatoren, Fließhilfen, Metalladditive zur Abschirmung elektromagnetischer Strahlung, Antistatika, Entformungsmittel, Farbstoffe, Pigmente, Haftvermittler, Verwitterungsschutzmittel, Weichmacher, Füllstoffe und dergleichen.

Im Rahmen einer besonders bevorzugten Ausführungsform der vorliegenden Erfindung wird mindestens ein sterisch gehindertes Amin eingesetzt, wodurch die Witterungsbeständigkeit weiter verbessert wird. Eine Gelbverfärbung oder ein Abbau der Materialien, die lange Zeit Außenbedingungen ausgesetzt werden, kann weiter verringert werden.

Besonders bevorzugte sterisch gehinderte Amine schließen Dimethylsuccinat-1-(2-hydroxyethyl)-4-hydroxy-2,2,6,6-tetramethylpiperazin-polykondensat, Poly[{6-(1,1,3,3-tetramethylbutyl)amino-1,3,5-triazin-2,4,-diyl}{(2.2,6,6-tetramethyl-4-piperidyl)imino}hexamethylen{(2,2,6,6-tetramethyl-4-piperidyl)imino}], N,N'-Bis(3-aminopropyl)ethylenediamin-2,4-bis[N-butyl-N-(1,2,2,6,6-pentamethyl-4-piperidyl)amino]-6-chlor-1,3,5-triazinkondensat, bis(2,2,6,6-Tetramethyl-4-piperidyl)sebazat und 2-(3,5-di-t-4-Hydroxybenzyl)-2-n-butylmalonat bis(1,2,2,6,6-pentamethyl-4-piperidyl) ein.

Weiterhin hat sich der Einsatz von Silanhaftvermittlern oder organischen Titanverbindungen ganz besonders bewährt, wodurch die Adhäsion an anorganischen Materialien weiter verbessert wird.

Geeignete Silanhaftvermittler schließen Vinyltrichlorosilan, Vinyl-tris(β-methoxyethoxy)silan, Vinyltriethoxysilan, Vinyltrimethoxysilan, γ-Methacryloxypropyltrimethoxysilan, β-(3,4-Epoxycyclohexyl)ethyltrimethoxysilan, γ-Glycidoxypropylmethyldiethoxysilan, N-β-(Aminoethyl)-γ-aminopropyltrimethoxysilan, N-β-(Aminoethyl)-γ-aminopropylmethyldimethoxysilan, γ-Aminopropyltriethoxysilan, N-Phenyl-γ-aminopropyltrimethoxysilan, γ-Mercaptopropyltrimethoxysilan und γ-Chlorpropyltrimethoxysilan ein.

Die relativen Anteile des Polyalkyl(meth)acrylats und der Verbindung gemäß Formel (I) können prinzipiell frei gewählt werden.

Zweckmäßigerweise liegen sie in einer gemeinsamen Formmasse vor. Besonders bevorzugte Formmassen umfassen, jeweils bezogen auf ihr Gesamtgewicht,
a) 90 Gew.-% bis 99,999 Gew.-% Polyalkyl(meth)acrylat und
b) 0,001 Gew.-% bis 0,03 Gew.-% Verbindung gemäß Formel (I)

Die Einarbeitung der Verbindungen in eine gemeinsame Formmasse kann nach den literaturbekannten Verfahren erfolgen, beispielsweise durch Vermischen mit dem Polymer vor der Weiterverarbeitung bei höherer Temperatur, durch Zugabe in die Schmelze des Polymeren oder durch Zugabe zu suspendiertem oder gelöstem Polymer während seiner Verarbeitung. Sie können gegebenenfalls auch bereits den Ausgangstoffen zur Herstellung des Polymers zugesetzt werden und verlieren auch in Gegenwart weiterer üblicher Licht- und Hitzestabilisatoren, Oxidations- und Reduktionsmitteln und dergleichen ihre Absorptionsfähigkeit nicht.

Eine für die Zwecke der vorliegenden Erfindung besonders bevorzugte Formmasse besitzt eine Erweichungstemperatur von nicht weniger als 80°C (Vicaterweichungstemperatur VET (ISO 306-B50)). Sie eignet sich daher insbesondere als Verfestigungsmittel für Solarzellenmodule, da sie nicht anfängt zu kriechen, selbst wenn das Modul bei der Verwendung hohen Temperaturen ausgesetzt wird.

Besonders vorteilhaft sind auch Formmassen, die eine vergleichsweise hohe Totallichtdurchlässigkeit besitzen und auf diese Weise insbesondere bei der Anwendung der Formmasse als Verfestigungsmittel in Solarzellmodulen einen Leistungsabfall der Solarzelle verhindern, der durch optischen Verlust des Verfestigungsmittels bedingt sein könnte. Über den Wellenlängenbereich von 400 nm bis kleiner 500 nm ist die Totallichtdurchlässigkeit vorzugsweise mindestens 90 %. Über den Wellenlängenbereich von 500 nm bis kleiner 1000 nm ist die Totallichtdurchlässigkeit vorzugsweise mindestens 80 % (Messung mithilfe des Spectralphotometer Lambda 19 von der Fa. Perkin Elmer).

Weiterhin sind auch Formmassen vorteilhaft, die einen Ableitwiderstand von 1 - 500 kΩ x cm² besitzen Eine Leistungsabnahme der Solarzelle aufgrund von Kurzschlüssen wird bestmöglich vermieden.

Formmassen, die die genannten Bestandteile enthalten, eignen sich insbesondere als Verfestigungsmittel für Solarzellenmodule. Weiterhin werden sie vorzugsweise zur Herstellung von sogenannten Lichtkonzentratoren verwendet. Hierbei handelt es um Bauteile, die Licht mit hoher Effizienz auf einer möglichst geringen Fläche konzentrieren, also eine hohe Bestrahlungsstärke erzielen. Es ist dabei nicht notwendig, ein Bild der Lichtquelle zu erzeugen.

Für die Zwecke der vorliegenden Erfindung besonders vorteilhafte Lichtkonzentratoren sind Sammellinsen, die parallel eingestrahltes Licht sammeln und in der Brennebene bündeln. Dabei wird insbesondere das parallel zur optischen Achse eingestrahlte Licht im Brennpunkt fokussiert.

Sammellinsen können bikonvex (beidseitig nach außen gewölbt), plankonvex (1 Seite plan, 1 Seite konvex) oder konkav-konvex (1 Seite nach Innen gewölbt, 1 Seite nach Außen gewölbt, wobei die konvexe Seite vorzugsweise stärker gewölbt ist als die konkave) sein. Erfindungsgemäß besonders bevorzugte Sammellinsen umfassen mindestens einen konvexen Bereich, wobei sich plankonvexe Strukturen als ganz besonders vorteilhaft erwiesen haben.

Im Rahmen einer besonders bevorzugten Ausführungsform der vorliegenden Erfindung weisen die Lichtkonzentratoren die Struktur einer Fresnel-Linse auf. Hierbei handelt es sich um eine optische Linse, die durch das angewendete Bauprinzip generell zu einer Gewichts- und Volumenverringerung führt, was sich im Besonderen bei großen Linsen mit kurzer Brennweite auswirkt.

Die Verringerung des Volumens geschieht bei der Fresnel-Linse durch eine Aufteilung in ringförmige Bereiche. In jedem dieser Bereiche wird die Dicke verringert, sodass die Linse eine Reihe ringförmiger Stufen erhält. Da Licht nur an der Oberfläche der Linse gebrochen wird, ist der Brechungswinkel nicht von der Dicke, sondern nur vom Winkel zwischen den beiden Oberflächen einer Linse abhängig. Deshalb behält die Linse ihre Brennweite bei, obwohl die Bildqualität durch die Stufenstruktur verschlechtert wird. Im Rahmen einer ersten besonders bevorzugten Ausführungsform der vorliegenden Erfindung werden rotationssymmetrische Linsen mit einer Fresnelsche Struktur zur optischen Achse eingesetzt. Sie bündeln das Licht in eine Richtung auf einen Punkt.

Im Rahmen einer weiteren besonders bevorzugten Ausführungsform der vorliegenden Erfindung werden lineare Linsen mit Fresnelscher Struktur verwendet, die das Licht in einer Ebene bündeln.

Im Übrigen kann das Solarzellenmodul einen an sich bekannten Aufbau aufweisen. Es umfasst vorzugsweise mindestens ein photovoltaisches Element, das zweckmäßiger Weise zwischen einer Scheibe und einer Rückwand eingelegt und laminiert ist, wobei die Scheibe und die Rückwand günstiger Weise jeweils mit einem Verfestigungsmittel am photovoltaischen Element befestigt sind. Dabei umfasst das Solarzellenmodul, insbesondere die Scheibe, die Rückwand und/oder die Verfestigungsmittel, vorzugsweise die erfindungsgemäß eingesetzten Komponenten, d.h. das Polyalkyl(meth)acrylat und die Verbindung gemäß Formel (I).

Im Rahmen einer weiteren ganz besonders bevorzugten Ausführungsform der vorliegenden Erfindung umfasst das Solarzellenmodul
a) mindestens ein photovoltaisches Element,
b) mindestens einen Lichtkonzentrator, der mindestens ein Polyalkyl(meth)acrylat enthält, und
c) mindestens eine transparente Scheibe, die mindestens eine Verbindung gemäß Formel (I) enthält.

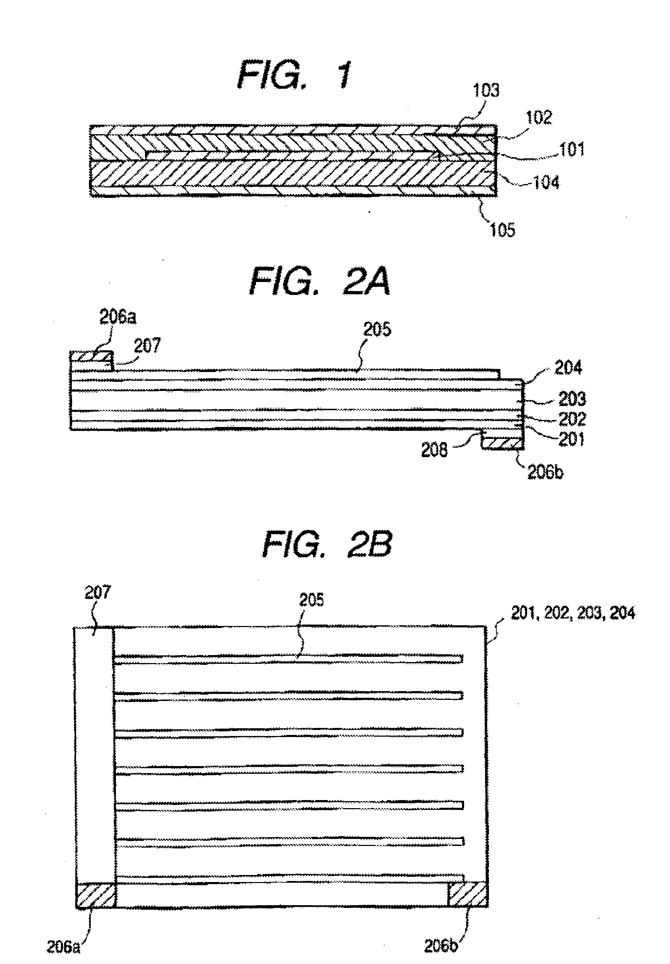

Ein besonders vorteilhafter Aufbau eines Solarzellenmoduls wird im Folgenden unter gelegentlicher Bezugnahme auf die Figuren Fig. 1 bis Fig. 2B beschrieben.

Das erfindungsgemäße Solarzellenmodul umfasst vorzugsweise ein photovoltaisches Element 101, eine Scheibe 103, die die Vorderseite des photovoltaisches Elements 101 bedeckt, ein erstes Verfestigungsmittel 102 zwischen dem photovoltaischen Element 101 und der Scheibe 103, eine Rückwand 105, die die Rückseite 104 des photovoltaisches Elements 101 bedeckt und ein zweites Verfestigungsmittel 104 zwischen dem photovoltaischen Element 101 und der Rückwand 105.

Das photovoltaische Element umfasst vorzugsweise eine photoaktive Halbleiterschicht auf einem leitfähigen Substrat als eine erste Elektrode zur Lichtumwandlung und eine transparente leitfähige Schicht als zweite Elektrode, die darauf gebildet ist.

Das leitfähige Substrat umfasst in diesem Zusammenhang vorzugsweise rostfreien Stahl, wodurch die Adhäsionsfestigkeit des Verfestigungsmittels am Substrat weiter verbessert wird.

Eine Sammelelektrode, die Kupfer und/oder Silber als Bestandteil enthält, wird vorzugsweise auf der lichtempfindlichen Seite des photovoltaischen Elements gebildet und ein Polyalkyl(meth)acrylat, das bevorzugt mindestens eine Verbindung gemäß Formel (I) enthält, wird vorzugsweise mit der Sammelelektrode in Kontakt gebracht. Die lichtempfindliche Oberfläche des photovoltaischen Elements wird günstiger Weise mit einem Polyalkyl(meth)acrylat, das bevorzugt mindestens eine Verbindung gemäß Formel (I) enthält, bedeckt und dann wird vorzugsweise ein dünner Fluoridpolymerfilm als äußerste Schicht darauf angeordnet.

Das erste Verfestigungsmittel 102 soll das photovoltaische Element 101 vor der Außeneinwirkung schützen, indem es Unebenheiten der lichtempfindlichen Oberfläche des Elements 101 bedeckt. Weiterhin dient es auch dazu, die Scheibe 103 an das Element 101 zu binden. Daher soll es eine hohe Witterungsbeständigkeit, eine große Adhäsion und eine hohe Wärmebeständigkeit zusätzlich zu einer hohen Transparenz aufweisen. Weiterhin soll es eine niedrige Wasserabsorption zeigen und keine Säure freisetzen. Um diesen Wünschen zu genügen, wird vorzugsweise ein Polyalkyl(meth)acrylat als erstes Verfestigungsmittel eingesetzt, das bevorzugt mindestens eine Verbindung gemäß Formel (I) enthält.

Um eine Reduktion der Lichtmenge zu minimieren, die das photovoltaische Element 101 erreicht, ist die Lichtdurchlässigkeit des ersten Verfestigungsmittels 102 im sichtbaren Wellenlängenbereich von 400 nm bis 800 nm vorzugsweise mindestens 80 %, besonders bevorzugt mindestens 90 % im Wellenlängenbereich von 400 nm bis kleiner 500 nm (Messung mithilfe des Spectralphotometer Lambda 19 von der Fa. Perkin Elmer). Weiterhin hat es vorzugsweise einen Brechungsindex von 1,1 - 2,0, vorteilhafter Weise von 1,1 - 1,6, um den Lichteinfall aus Luft zu erleichtern (Messung nach ISO 489).

Das zweite Verfestigungsmittel 104 wird verwendet, um das photovoltaische Element 101 vor Außeneinwirkungen zu schützen, indem Unebenheiten auf der Rückseite des Elements 101 bedeckt werden. Weiterhin dient es auch dazu, die Rückwand 105 an das Element 101 zu binden. Daher soll das zweite Verfestigungsmittel wie das erste Verfestigungsmittel eine hohe Witterungsbeständigkeit, eine große Adhäsion und eine hohe Wärmebeständigkeit aufweisen. Es ist daher bevorzugt, ein Polyalkyl(meth)acrylat, das bevorzugt mindestens eine Verbindung gemäß Formel (I) enthält, auch als zweites Verfestigungsmittel zu verwenden. Vorzugsweise wird das gleiche Material sowohl für das erste Verfestigungsmittel als auch für das zweite Verfestigungsmittel eingesetzt. Da jedoch die Transparenz optional ist, kann bei Bedarf ein Füllstoff, wie ein organisches Oxid, zum zweiten Verfestigungsmittel zugegeben werden, um die Witterungsbeständigkeit und die mechanischen Eigenschaften weiter zu verbessern, oder ein Pigment kann zugegeben werden, um es anzufärben.

Als photovoltaisches Element 101 werden vorzugsweise bekannte Elemente, insbesondere monokristalline Siliziumzellen, multikristalline Siliziumzellen, amorphes Silizium und mikrokristallines Silizium eingesetzt, wie sie auch in Dünnschichtsiliziumzellen verwendet werden. Weiterhin sind auch Kupfer-Indium-Selenid- und Halbleiterverbindungen besonders geeignet.

Ein schematisches Blockdiagramm eines bevorzugten photovoltaischen Elements wird in Figs. 2a und 2b gezeigt. Fig. 2a ist eine schematische Querschnittsansicht eines photovoltaischen Elements, wohingegen Fig. 2b eine schematische Draufsicht auf ein photovoltaisches Element ist. In diesen Figuren bezeichnet die Nummer 201 ein leitendes Substrat, 202 eine reflektierende Schicht auf der Rückseite, 203 eine photoaktive Halbleiterschicht, 204 eine transparente, leitende Schicht, 205 eine Sammelelektrode, 206a und 206b Abgreifklemmen und 207 und 208 leitende, adhäsive oder leitende Pasten.

Das leitende Substrat 201 dient nicht nur als Substrat des photovoltaischen Elements, sondern auch als zweite Elektrode. Das Material des leitenden Substrats 201 umfasst vorzugsweise Silizium, Tantal, Molybdän, Wolfram, rostfreien Stahl, Aluminium, Kupfer, Titan, eine Karbonfolie, eine verbleite Stahlplatte, einen Harzfilm und/oder Keramik mit einer leitfähigen Schicht darauf.

Auf dem leitenden Substrat 201 ist vorzugsweise eine Metallschicht, eine Metalloxidschicht oder beides als' reflektierende Schicht 202 auf der Rückseite vorgesehen. Die Metallschicht umfasst vorzugsweise Ti, Cr, Mo, B, Al, Ag und/oder Ni, wohingegen die Metalloxidschicht vorzugsweise ZnO, TiO₂ und SnO₂ enthält. Die Metallschicht und die Metalloxidschicht werden zweckmäßiger Weise durch Gasphasenabscheidung durch Erwärmen oder durch Elektronenstrahl oder durch Sputtern gebildet.

Die photoaktive Halbleiterschicht 203 dient zur Durchführung der photoelektrischen Umwandlung. In diesem Zusammenhang bevorzugte Materialen sind multikristallines Silizium mit pn-Übergang, Pin Junction-Typen aus amorphes Silizium, Pin Junction-Typen aus mikrokristallines Silizium und Halbleiterverbindungen, insbesondere CulnSe₂, CulnS₂, GaAs, CdS/Cu₂S, CdS/CdTe, CdS/InP und CdTe/Cu₂Te. Der Einsatz von Pin Junction-Type aus amorphem Silizium wird dabei besonders bevorzugt.

Die Herstellung der photoaktiven Halbleiterschicht erfolgt vorzugsweise, indem man geschmolzenes Silizium in eine Folie umformt, oder durch Wärmebehandlung von amorphem Silizium im Falle von polykristallinem Silizium, durch Plasmagasphasenabscheidung unter Verwendung eines Silangases als Ausgangsmaterial im Falle von amorphem Silizium und mikrokristallinem Silizium und durch lonenplattieren, lonenstrahlabscheidung, Vakuumverdampfen, Sputtern oder Galvanisieren im Falle einer Halbleiterverbindung.

Die transparente leitfähige Schicht 204 dient als obere Elektrode der Solarzelle. Sie umfasst vorzugsweise In₂O₃, SnO₂, In₂O₃-SnO₂(ITO), ZnO, TiO₂, Cd₂SnO₄ oder eine kristalline Halbleiterschicht, die mit einer großen Konzentration an Verunreinigungen dotiert ist. Sie kann durch Widerstandserwärmen-Aufdampfen, Sputtern, Sprühen, Gasphasenabscheidung oder durch Diffusion von Verunreinigungen gebildet werden. Im Übrigen können bei dem photovoltaischen Element, auf welchem die transparente leitfähige Schicht 204 gebildet wurde, das leitfähige Substrat und die transparente, leitende Schicht teilweise wegen der Unebenheit der Oberfläche des leitfähigen Substrats 201 und/oder der Nicht-Einheitlichkeit zum Zeitpunkt der Bildung der photoaktiven Halbleiterschicht kurzgeschlossen sein. In diesem Fall kommt es zu einem großen Stromverlust proportional zur Ausgabespannung. D.h. der Leckwiderstand (Nebenwiderstand) ist niedrig. Daher ist es wünschenswert, die Kurzschlüsse zu beheben und das photovoltaische Element nach der Bildung der transparenten leitfähigen Schicht einer Behandlung zur Entfernung von Fehlstellen zu unterziehen. Eine derartige Behandlung wird im Patent US 4,729,970 im Detail beschrieben. Durch diese Behandlung wird der Nebenwiderstand des photovoltaischen Elements auf 1 - 500 kΩ x cm², vorzugsweise auf 10 - 500 kΩ x cm², eingestellt.

Auf der transparenten leitfähigen Schicht 204 kann die Sammelelektrode (Gitternetz) gebildet werden. Sie hat vorzugsweise die Gestalt eines Gitternetzes, eines Kamms, einer Linie oder ähnliches, um den elektrischen Strom effektiv zu sammeln. Bevorzugte Beispiele des Materials, das die Sammelelektrode 205 bildet, sind Ti, Cr, Mo, W, Al, Ag, Ni, Cu, Sn oder eine leitfähige Paste, die als Silberpaste bezeichnet wird.

Die Sammelelektrode 205 wird bevorzugt durch Sputtern unter Verwendung eines Maskierungsmusters, durch Widerstandserwärmung, durch Gasphasenabscheidung, durch ein Verfahren, umfassend die Schritte, dass man einen Metallfilm über die gesamte Schicht durch Gasabscheidung bildet und nicht benötigte Teile des Films durch Ätzen entfernt, durch ein Verfahren, bei welchem man ein Gitterelektrodenmuster durch photochemische Gasphasenabscheidung bildet, durch ein Verfahren, umfassend die Schritte, dass man ein negatives Markierungsmuster der Gitterelektrode bildet und die gemusterte Oberfläche plattiert, durch ein Verfahren, bei welchem man eine leitfähige Paste aufdruckt, durch ein Verfahren, bei welchem man Metalldrähte auf eine gedruckte leitfähige Paste auflötet, gebildet. Als leitfähige Paste wird vorzugsweise ein Bindemittelpolymer verwendet, in welchem Silber, Gold, Kupfer, Nickel, Karbon oder ähnliches in Form eines feinen Pulvers dispergiert ist. Das Bindemittelpolymer schließt vorzugsweise Polyesterharze, Ethoxyharze, Acrylharze, Alkydharze, Polyvinylacetatharze, Gummis, Urethanharze und/oder Phenolharze ein.

Schließlich werden vorzugsweise Abgreifenden 206 am leitfähigen Substrat 201 bzw. an der Sammelelektrode 205 befestigt, um die elektromotorische Kraft abzugreifen. Die Befestigung der Abgreifenden 206 am leitfähigen Substrat wird vorzugsweise erreicht, indem man einen Metallkörper, wie z.B. eine Kupfernase, am leitfähigen Substrat durch Punktschweißen oder Löten befestigt, während die Befestigung der Abgreifenden an der Sammelelektrode vorzugsweise bewerkstelligt wird, indem man einen Metallkörper mit der Sammelelektrode mittels einer leitfähigen Paste oder mittels Lötzinn 207 und 208 elektrisch verbindet.

Die photovoltaischen Elemente werden gemäß der gewünschten Spannung oder Stromstärke entweder in Reihe oder parallel geschaltet. Weiterhin kann die Spannung oder Stromstärke gesteuert werden, indem man die photovoltaischen Elemente in ein isolierendes Substrat einfügt.

Die Scheibe 103 in Fig. 1 soll eine möglichst hohe Witterungsbeständigkeit, eine möglichst gute schmutzabweisende Wirkung und eine möglichst große mechanische Festigkeit besitzen, da sie die äußerste Schicht des Solarzellenmoduls ist. Weiterhin soll sie die Langzeitzuverlässlichkeit des Solarzellenmoduls bei Außenanwendung sicherstellen. Scheiben, die für die Zwecke der vorliegenden Erfindung in geeigneter Weise verwendet werden können, schließen (verstärkte) Glasfolien und Fluoridpolymerfilme ein. Als Glasfolie wird eine Glasfolie mit hoher Lichtdurchlässigkeit bevorzugt verwendet. Geeignete Fluoridpolymerfolien umfassen insbesondere Ethylentetrafluorid-Ethylencopolymer (ETFE), Polyvinylfluoridharz (PVF), Polyvinylidenfluoridharz (PVDF), Tetrafluorethylenharz (TFE), Ethylentetrafluorid-Propylenhexafluoridcopolymer (FEP) und Chlortrifluorethylen (CTFE). Das Polyvinylidenfluoridharz ist hinsichtlich der Witterungsbeständigkeit besonders geeignet, während das Ethylentetrafluorid-Ethylencopolymer hinsichtlich der Kombination aus Witterungsbeständigkeit und mechanischer Festigkeit besonders vorteilhaft ist. Um die Adhäsion zwischen der Fluoridpolymerfolie und dem Verfestigungsmittel zu verbessern, ist es wünschenswert, die Folie einer Koronabehandlung oder einer Plasmabehandlung zu unterziehen. Weiterhin werden auch gestreckte Folien bevorzugt verwendet, um die mechanische Festigkeit weiter zu verbessern.

Im Rahmen einer besonders bevorzugten Ausführungsform der vorliegenden Erfindung umfasst die Scheibe mindestens ein Polyalkyl(meth)acrylat, das bevorzugt weiterhin mindestens eine Verbindung gemäß Formel (I) enthält,

Die Scheibe ist weiterhin vorzugsweise ein Lichtkonzentrator, der Licht mit hoher Effizienz auf dem photovoltaischen Element konzentriert, also eine hohe Bestrahlungsstärke erzielt. Besonders bevorzugt werden Sammellinsen, die parallel eingestrahltes Licht sammeln und in der Brennebene bündeln. Dabei wird insbesondere das parallel zur optischen Achse eingestrahlte Licht im Brennpunkt fokussiert.

Die Sammellinsen können bikonvex, plankonvex oder konkav-konvex sein. Jedoch werden plankonvexe Strukturen besonders bevorzugt. Weiterhin weist die Scheibe vorzugsweise die Struktur einer Fresnel-Linse auf.
Die Rückwand 105 dient der elektrischen Isolation zwischen dem photovoltaischen Element 101 und der Umgebung und zur Verbesserung der Witterungsbeständigkeit und wirkt als verstärkendes Material. Sie ist vorzugsweise aus einem Material gebildet, das hinreichende elektrisch isolierende Eigenschaften sicherstellt, eine exzellente Langzeitbeständigkeit aufweist, thermischer Ausdehnung und thermischer Kontraktion widerstehen kann und das flexibel ist. Für diese Zwecke besonders geeignete Materialien schließen Nylonfolien, Polyethylenterephthalat (PET)-Folien und Polyvinylfluoridfolien ein. Wird eine Feuchtigkeitsbeständigkeit gefordert, so werden bevorzugt Aluminium-laminierte Polyvinylfluoridfolien, Aluminium-beschichtete PET-Folien, Siliziumoxid-beschichtete PET-Folien verwendet. Weiterhin kann die Feuerbeständigkeit des Moduls verbessert werden, indem man eine folienlaminierte, galvanisierte Eisenfolie oder eine Folie aus rostfreiem Stahl als Rückwand verwendet. Im Rahmen einer besonders bevorzugten Ausführungsform der vorliegenden Erfindung umfasst die Rückwand mindestens ein Polyalkyl(meth)acrylat, das bevorzugt weiterhin mindestens eine Verbindung gemäß Formel (I) enthält.

Auf der Außenoberfläche der Rückwand kann eine stützende Platte befestigt sein, um die mechanische Festigkeit des Solarzellenmoduls weiter zu verbessern oder um ein Ausbeulen und Durchbiegen der Rückwand in Folge von Temperaturänderungen zu verhindern. Besonders bevorzugte Rückwände sind Bleche aus rostfreiem Stahl, Kunststoffbleche und Bleche aus FRP (faserverstärkter Kunststoff). Weiterhin kann ein Baustoff an der Rückscheibe befestigt sein.

Die Herstellung eines derartigen Solarzellenmoduls kann auf an sich bekannte Weise erfolgen. Besonders zweckmäßig ist jedoch eine Vorgehensweise, die im Folgenden beschrieben wird.

Um das photovoltaische Element mit dem Verfestigungsmittel zu bedecken, wird vorzugsweise ein Verfahren verwendet, bei welchem man das Verfestigungsmittel thermisch aufschmilzt und durch einen Schlitz extrudiert, um eine Folie zu bilden, die dann thermisch am Element befestigt wird. Die Verfestigungsmittelfolie wird vorzugsweise zwischen dem Element und der Scheibe eingebracht und zwischen dem Element und der Rückwand und dann verfestigt.

Zur Durchführung der thermischen Verfestigung können bekannte Verfahren, wie z.B. Vakuumlaminierung und Rolllaminierung, verwendet werden.

Das erfindungsgemäße Solarzellenmodul hat vorzugsweise eine Betriebstemperatur von bis zu 80°C oder höher, wobei insbesondere bei hohen Temperaturen der wärmebeständige Effekt der erfindungsgemäßen Materialien effektiv genutzt werden kann.

## Patentansprüche

1. Verwendung von
a) mindestens einem Polyalkyl(meth)acrylat und
b) mindestens eine Verbindung gemäß Formel (I), 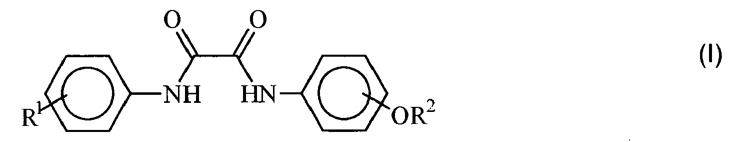 worin die Reste R¹ und R² unabhängig einen Alkyl- oder Cycloalkylrest mit 1 bis 20 Kohlenstoffatomen darstellen,
zur Herstellung von Solarzellenmodulen.

2. Verwendung nach Anspruch 1, **dadurch gekennzeichnet, dass** die Formmasse mindestens ein C₁-C₁₈-Alkyl(meth)acrylat-Homopolymer oder -Copolymer enthält.

3. Verwendung nach Anspruch 2, **dadurch gekennzeichnet, dass** die Formmasse mindestens ein Copolymer enthält, das 80 Gew.-% bis 99 Gew.-% Methylmethacrylat-Einheiten und 1 Gew.-% bis 20 Gew.-% C₁-C₁₀-Alkylacrylat-Einheiten umfasst.

4. Verwendung nach Anspruch 3, **dadurch gekennzeichnet, dass** das Copolymer Methylacrylat- und/oder Ethylacrylat-Einheiten umfasst.

5. Verwendung nach mindestens einem der vorangehenden Ansprüche, **dadurch gekennzeichnet, dass** eine Verbindung gemäss Formel (I) eingesetzt wird, bei welcher die Reste R¹ und R² unabhängig einen Alkyl- oder Cycloalkylrest mit 1 bis 8 Kohlenstoffatomen darstellen.

6. Verwendung nach mindestens einem der vorangehenden Ansprüche, **dadurch gekennzeichnet, dass** eine Verbindung gemäß Formel (I) eingesetzt wird, bei welcher die Reste R¹ und R² eine Methyl-, Ethyl-, Propyl-, Isopropyl-, 1-Butyl-, 2-Butyl-, 2-Methylpropyl-, tert.-Butyl-, Pentyl-, 2-Methylbutyl-, 1,1-Dimethylpropyl-, Hexyl-, Heptyl-, Octyl-, 1,1,3,3-Tetramethylbutyl, Nonyl-, 1-Decyl-, 2-Decyl-, Undecyl-, Dodecyl-, Pentadecyl- oder eine Eicosyl-Gruppe darstellen.

7. Verwendung nach mindestens einem der vorangehenden Ansprüche, **dadurch gekennzeichnet, dass** eine Verbindung gemäß Formel (I) eingesetzt wird, bei welcher die Reste R¹ und R² eine Cyclopropyl-, Cyclobutyl-, Cyclopentyl-, Cyclohexyl-, Cycloheptyl- oder eine Cyclooctyl-Gruppe darstellen, die gegebenenfalls mit verzweigten oder nicht verzweigten Alkylgruppen substituiert sind.

8. Verwendung nach mindestens einem der vorangehenden Ansprüche, **dadurch gekennzeichnet, dass** eine Verbindung gemäß Formel (II) 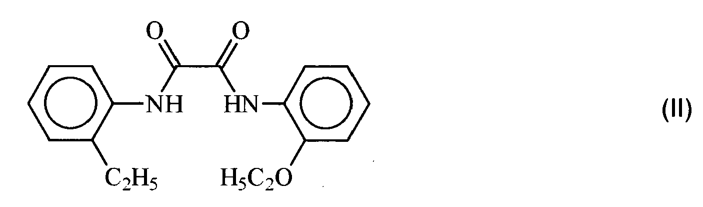 eingesetzt wird.

9. Solarzellenmodul, umfassend Formteile, enthaltend
a) mindestens ein Polyalkyl(meth)acrylat und
c) mindestens eine Verbindung gemäß Formel (I), 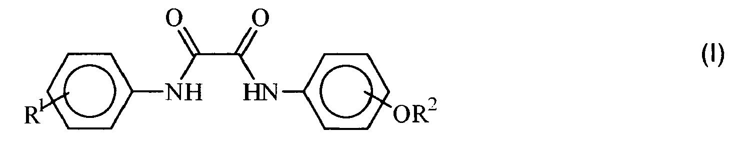 worin die Reste R¹ und R² unabhängig einen Alkyl- oder Cycloalkylrest mit 1 bis 20 Kohlenstoffatomen darstellen.

10. Solarzellenmodul nach Anspruch 9, **dadurch gekennzeichnet, dass** das Formteil ein Lichtkonzentrator ist.

11. Solarzellenmodul nach Anspruch 10, **dadurch gekennzeichnet, dass** das Formteil eine Sammellinse ist.

12. Solarzellenmodul nach Anspruch 11, **dadurch gekennzeichnet, dass** die Sammellinse einen konvexen Bereich umfasst.

13. Solarzellenmodul nach Anspruch 12, **dadurch gekennzeichnet, dass** die Sammellinse eine plankonvexe Struktur aufweist.

14. Solarzellenmodul nach Anspruch 13, **dadurch gekennzeichnet, dass** die Sammellinse eine Fresnel-Linse ist.

15. Solarzellenmodul nach mindestens einem der Ansprüche 10 bis 14, **dadurch gekennzeichnet, dass** es weiterhin ein photovoltaisches Element umfasst.

16. Solarzellenmodul, umfassend
a) mindestens ein photovoltaisches Element,
b) mindestens eine Sammellinse, die mindestens ein Polyalkyl(meth)acrylat enthält, und
c) mindestens eine transparente Scheibe, die mindestens eine Verbindung gemäß Formel (I) enthält 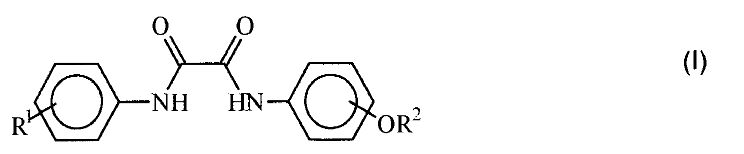 worin die Reste R¹ und R² unabhängig einen Alkyl- oder Cycloalkylrest mit 1 bis 20 Kohlenstoffatomen darstellen.

## Claims

1. Use of
a) at least one polyalkyl (meth)acrylate and
b) at least one compound according to formula (I) 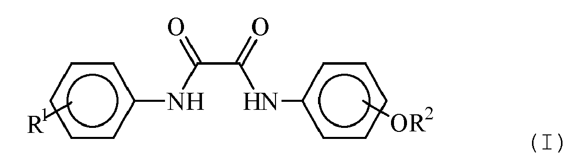 in which the moieties R¹ and R² are independently an alkyl or cycloalkyl moiety having from 1 to 20 carbon atoms,
for the production of solar-cell modules.

2. Use according to Claim 1, **characterized in that** the moulding composition comprises at least one C₁-C₁₈-alkyl (meth)acrylate homopolymer or C₁-C₁₈-alkyl (meth)acrylate copolymer.

3. Use according to Claim 2, **characterized in that** the moulding composition comprises at least one copolymer which encompasses from 80% by weight to 99% by weight of methyl methacrylate units and from 1% by weight to 20% by weight of C₁-C₁₀-alkyl acrylate units.

4. Use according to Claim 3, **characterized in that** the copolymer encompasses methyl acrylate units and/or ethyl acrylate units.

5. Use according to at least one of the preceding claims, **characterized in that** a compound according to formula (I) is used in which the moieties R¹ and R² are independently an alkyl or cycloalkyl moiety having from 1 to 8 carbon atoms.

6. Use according to at least one of the preceding claims, **characterized in that** a compound according to formula (I) is used in which the moieties R¹ and R² are a methyl, ethyl, propyl, isopropyl, 1-butyl, 2-butyl, 2-methylpropyl, tert-butyl, pentyl, 2-methylbutyl, 1,1-dimethylpropyl, hexyl, heptyl, octyl, 1,1,3,3-tetramethylbutyl, nonyl, 1-decyl, 2-decyl, undecyl, dodecyl, pentadecyl or eicosyl group.

7. Use according to at least one of the preceding claims, **characterized in that** a compound according to formula (I) is used in which the moieties R¹ and R² are a cyclopropyl, cyclobutyl, cyclopentyl, cyclohexyl, cycloheptyl or cyclooctyl group, optionally having branched or unbranched alkyl groups as substituents.

8. Use according to at least one of the preceding claims, **characterized in that** a compound according to formula (II) 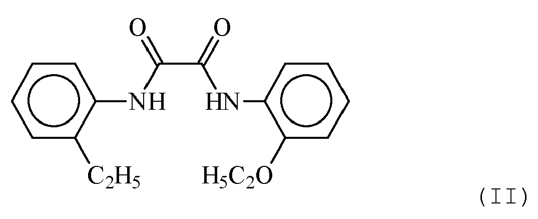 is used.

9. Solar-cell module, encompassing mouldings, comprising
a) at least one polyalkyl (meth)acrylate and
b) at least one compound according to formula (I) 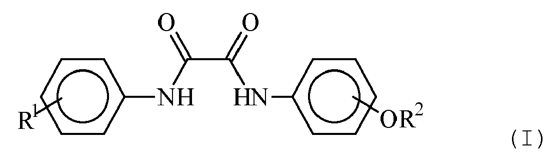 in which the moieties R¹ and R² are independently an alkyl or cycloalkyl moiety having from 1 to 20 carbon atoms.

10. Solar-cell module according to Claim 9, **characterized in that** the moulding is a light concentrator.

11. Solar-cell module according to Claim 10, **characterized in that** the moulding is a converging lens.

12. Solar-cell module according to Claim 11, **characterized in that** the converging lens encompasses a convex region.

13. Solar-cell module according to Claim 12, **characterized in that** the converging lens has a planoconvex structure.

14. Solar-cell module according to Claim 13, **characterized in that** the converging lens is a Fresnel lens.

15. Solar-cell module according to at least one of Claims 10 to 14, **characterized in that** it moreover, encompasses a photovoltaic element.

16. Solar-cell module, encompassing
a) at least one photovoltaic element
b) at least one converging lens, which comprises at least one polyalkyl (meth)acrylate,
and
c) at least one transparent pane, which comprises at least one compound according to formula (I) 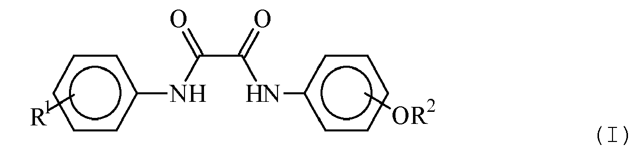 in which the moieties R¹ and R² are independently an alkyl or cycloalkyl moiety having from 1 to 20 carbon atoms.

## Revendications

1. Utilisation de
a) au moins un poly((méth)acrylate d'alkyle) et
b) au moins un composé de formule (I) 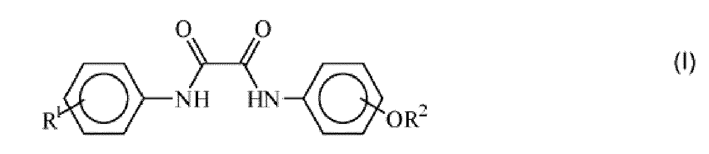 dans laquelle les groupes R¹ et R² représentent indépendamment un groupe alkyle ou cycloalkyle comptant de 1 à 20 atomes de carbone,
pour la fabrication de modules de cellules solaires.

2. Utilisation selon la revendication 1, **caractérisée en ce que** la pâte de moulage contient au moins un homopolymère ou un copolymère de (méth)acrylate d'alkyle en C₁ à C₁₈.

3. Utilisation selon la revendication 2, **caractérisée en ce que** la pâte de moulage contient au moins un copolymère qui comporte de 80 % en poids à 99 % en poids d'unités de méthacrylate de méthyle et de 1 % en poids à 20 % en poids d'unités d' acrylate d'alkyle en C₁ à C₁₀.

4. Utilisation selon la revendication 3, **caractérisée en ce que** le copolymère comporte des unités d'acrylate de méthyle et/ou d'acrylate d'éthyle.

5. Utilisation selon au moins l'une des revendications précédentes, **caractérisée en ce qu'**elle recourt à un composé de formule (I) dans lequel les groupes R¹ et R² représentent indépendamment un groupe alkyle ou cycloalkyle comptant de 1 à 8 atomes de carbone.

6. Utilisation selon au moins l'une des revendications précédentes, **caractérisée en ce qu'**elle recourt à un composé de formule (I) dans lequel les groupes R¹ et R² représentent un groupe méthyle, éthyle, propyle, isopropyle, 1-butyle, 2-butyle, 2-méthylpropyle, tert.-butyle, pentyle, 2-méthylbutyle, 1,1-diméthylpropyle, hexyle, heptyle, octyle, 1,1,3,3-tétraméthylbutyle, nonyle, 1-décyle, 2-décyle, undécyle, dodécyle, pentadécyle ou éicosyle.

7. Utilisation selon au moins l'une des revendications précédentes, **caractérisée en ce qu'**elle recourt à un composé de formule (I) dans lequel les groupes R¹ et R² représentent un groupe cyclopropyle, cyclobutyle, cyclopentyle, cyclohexyle, cycloheptyle ou un groupe cyclooctyle qui peut éventuellement être substitué avec des groupes alkyle ramifiés ou non ramifiés.

8. Utilisation selon au moins l'une des revendications précédentes, **caractérisée en ce qu'**elle recourt à un composé de formule (II)

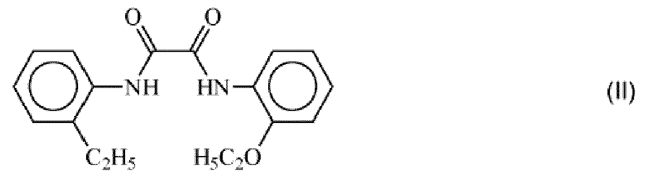

9. Module de cellule solaire comprenant des pièces moulées qui contiennent
a) au moins un poly((méth)acrylate d'alkyle) et
b) au moins un composé de formule (I) 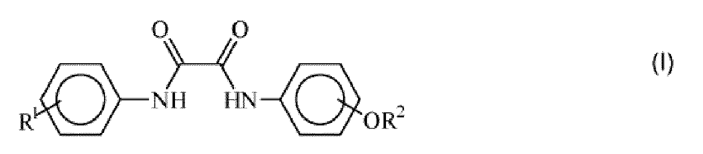 dans laquelle les groupes R¹ et R² représentent indépendamment un groupe alkyle ou cycloalkyle comptant de 1 à 20 atomes de carbone.

10. Module de cellule solaire selon la revendication 9, **caractérisé en ce que** la pièce moulée est un concentrateur de lumière.

11. Module de cellule solaire selon la revendication 10, **caractérisé en ce que** la pièce moulée est une lentille convergente.

12. Module de cellule solaire selon la revendication 11, **caractérisé en ce que** la lentille convergente comporte une partie convexe.

13. Module de cellule solaire selon la revendication 12, **caractérisé en ce que** la lentille convergente présente une structure plan-convexe.

14. Module de cellule solaire selon la revendication 13, **caractérisé en ce que** la lentille convergente est une lentille de Fresnel.

15. Module de cellule solaire selon au moins l'une des revendications 10 à 14, **caractérisé en ce qu'**il comporte en outre un élément photovoltaïque.

16. Module de cellule solaire comprenant
a) au moins un élément photovoltaïque,
b) au moins une lentille convergente qui contient au moins un poly((méth)acrylate d'alkyle) et
c) au moins une vitre transparente qui contient au moins un composé de formule (I) 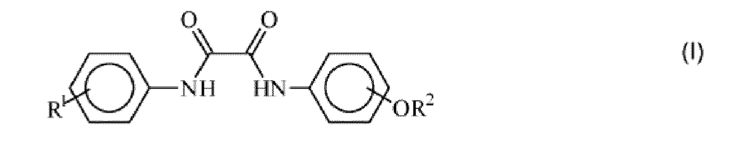 dans laquelle les groupes R¹ et R² représentent indépendamment un groupe alkyle ou cycloalkyle comptant de 1 à 20 atomes de carbone.
